# EUROPEAN PATENT APPLICATION

(11) **EP 0 977 044 A1**
(43) Date of publication of application: **02.02.2000**
(21) Application number: 99305752.0
(22) Date of filing: 20.07.1999
(51) Int. Cl.: G01R 29/10

(54) **Mastless antenna test device**

(30) Priority: 31.07.1998 JP 21774298
(71) Applicant: HARADA INDUSTRY CO., LTD., Shinagawa-ku Tokyo (JP)
(72) Inventor: Maeda, Yuji, Koshiya-Heim-Omorihigashi 1-35-5-310, Tokyo (JP)
(74) Representative: Butcher, Ian James

(57) **Abstract**

A mastless antenna test device comprises a test device main body (30) which is removably connectably provided to a mastless antenna (2, 21, 22, 23) for a vehicle which is constructed by a plurality of antenna elements (TV1 to TV4, AM, FM1 to FM4) for receiving various electric waves such as TV wave, AM wave, and FM wave through connectors (5, 6), transmission section (31, 32, 4) to be placed in the test device main body (30) and to include transmission antenna (4) which can selectively transmit the various radio waves to the mastless antenna (2, 21, 22, 23), individual reception section (33, 34, 35, 39b) which individually takes out and receives a specific antenna output among a plurality of antenna outputs obtained from the plurality of antenna elements (TV1 to TV4, AM, FM1 to FM4) in response to one kind of radio waves transmitted, judgment section (36) which judges a quality of an antenna output received, and information section (37) which informs a judgment result.

## Description

The present invention relates to a mastless antenna test device to test performance of antenna without a part which greatly projects outside of a vehicle body such as a vehicle pane antenna (hereinafter, called as a "mastless antenna" in the present invention).

In general, this kind of mastless antenna is mounted in a state, which is almost completely integrated with the body, for example, as is represented as the vehicle pane antenna as if each antenna element is assimilated into a part of the body. In a case of an example of the vehicle pane antenna, a long and narrow thin film conductor, which forms a predetermined pattern having translucent property on the vehicle pane, is an antenna element.

In the conventional art, means for testing by connecting the test device main body with each antenna element by a number of coaxial cables, each of which comprises the connector for the test, has been entirely adopted as means for testing the mastless antenna with such a configuration.

Thus, when the test is performed, since the test device main body is connected with each antenna element by a number of coaxial cables, each of which entirely comprises the connector, the preparation work is very complex before starting the test. Especially, when the test is performed by disconnecting a part of antenna circuit, since another connection cable is required, above-mentioned preparation work becomes more complex. Thus, it is difficult to perform the test promptly and adequately.

An object of the present invention is to provide a mastless antenna test device in which connection between a test device main body and each antenna element is easy, a preparation work before starting the test is easy, and in addition, the test of the vehicle mastless antenna can be performed promptly and adequately.

To solve the subject matter and achieve the object, the device of the present invention is constructed As follows. Configurations with the features other than the following configuration will be clarified in the embodiment.

The mastless antenna test device according to the present invention comprises: a test device main body which is removably connectably provided to a mastless antenna for a vehicle which is constructed by a plurality of antenna elements for receiving various electric waves such as TV wave, AM wave, and FM wave through connectors, transmission means to be placed in the test device main body and to include transmission antenna which can selectively transmit the various radio waves to the mastless antenna, individual reception means which individually takes out and receives a specific antenna output among a plurality of antenna outputs obtained from the plurality of antenna elements in response to one kind of radio waves transmitted, judgment means which judges a quality of an antenna output received, and information means which informs a judgment result.

According to the present invention, various radio waves are selectively transmitted from the transmission antenna of the test device main body to the mastless antenna, which is integrated to the body, and only an output of an antenna output from a specific antenna element of the above-mentioned mastless antenna is individually received and tested. Therefore, it is possible to provide a mastless antenna test device in which the connection between the test device main body and each antenna element is easy, the preparation work before starting the test is easy, and in addition, the test of the vehicle mastless antenna can be performed promptly and adequately.

This summary of the invention does not necessarily describe all necessary features so that the invention may also be a sub-combination of these described features.

The invention can be more fully under stood from the following detailed description when taken in conjunction with the accompanying drawings, in which:
FIG. 1A and FIG. 1B are figures which show an outline configuration of the mastless antenna test device according to an embodiment of the present invention;
FIG. 2 is a figure which shows the configuration of the mastless antenna test device according to an embodiment of the present invention, and is a figure which shows the state of connecting the mastless antenna test device with the pane antenna device with connectors;
FIG. 3 is a figure which shows the configuration of the mastless antenna test device according to an embodiment of the present invention, and is a figure which shows an internal configuration of the test device main body; and
FIG. 4 is a figure which shows an operation of the mastless antenna test device according to an embodiment of the present invention, and an operation explanation chart of an example of the test of FM diversity function.

A mastless antenna according to an embodiment of the present invention will be explained referring to the drawings.

### (Configuration)

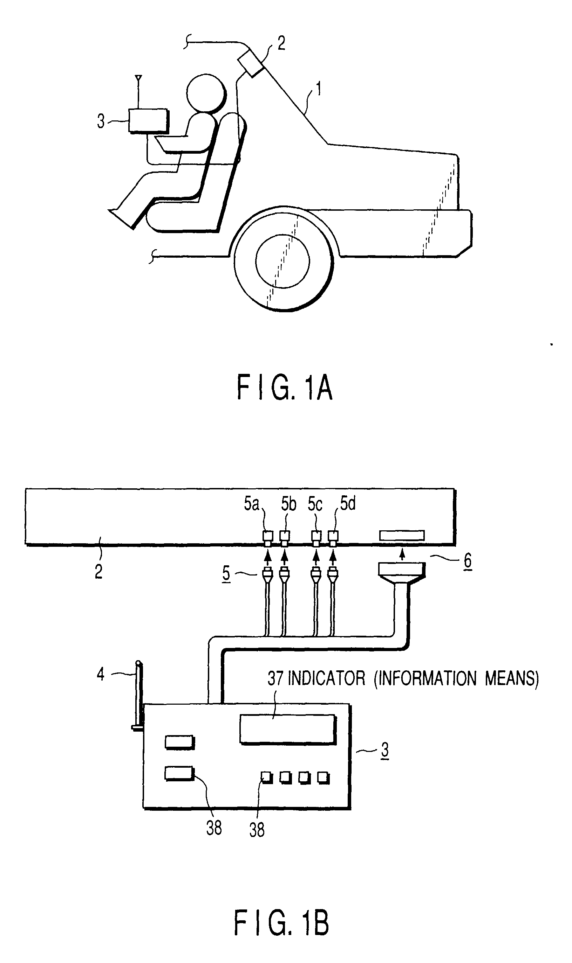

FIG. 1A and FIG. 1B are figures which show an outline configuration of the mastless antenna test device according to an embodiment of the present invention.

In FIG. 1A, pane antenna device 2 is allocated on rear window 1 in the vehicle. Mastless antenna test device 3 is removably connected to this pane antenna device 2.

Transmission antenna 4 is placed in mastless antenna test device 3 as shown in FIG. 1B. This transmission antenna 4 is an antenna which can selectively transmit various radio waves such as TV wave, AM wave, and FM wave to the pane antenna device 2. Pane antenna device 2 and mastless antenna test device 3 are connected by connector group 5 and power supply control connector 6 as shown in FIG. 1B. Connector group 5 has connector 5a for the AM/FM antenna signal, connector 5b for the FM-IF signal, connector 5c for the TV antenna signal, and connector 5d for the video signal. Indicator 37 and operation switch 38, etc. for displaying the test result described later are arranged in front of the case of the mastless antenna test device 3.

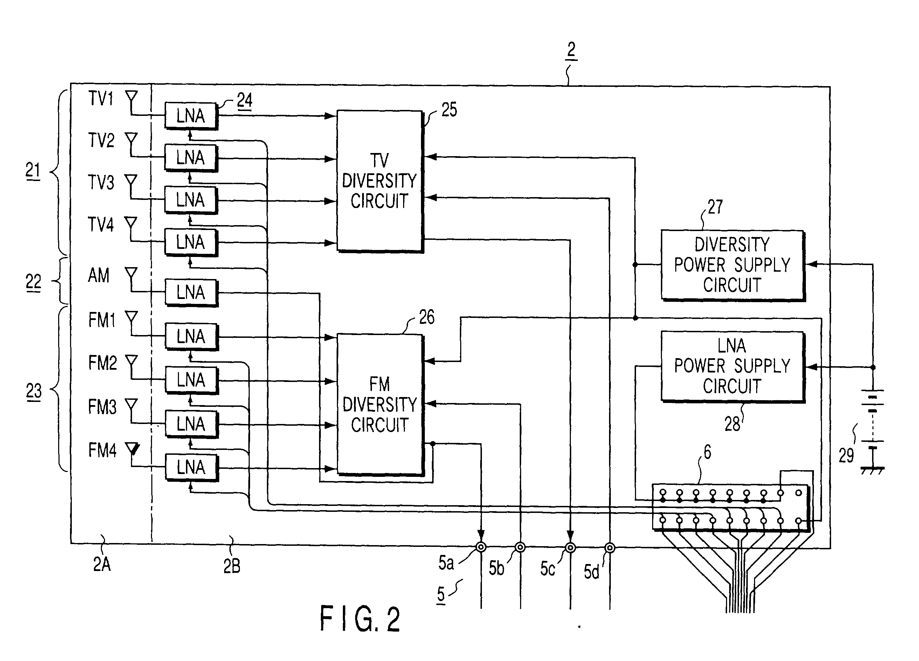

FIG. 2 is a figure which shows the state of connecting pane antenna device 2 with mastless antenna test device 3 by connectors. Pane antenna device 2 has antenna section 2A and attached device section 2B as shown in FIG. 2.

The antenna section 2A is an antenna element, in which a translucent long and narrow thin film conductor is formed to a predetermined pattern on the pane, and has a TV wave reception antenna 21 (antenna elements TV1 to TV4), an AM wave reception antenna 22 (antenna element AM), and an FM wave reception antenna 23 (antenna elements FM1 to FM4).

Attached device section 2B is constructed by providing low noise amplifier (LNA) 24, TV diversity circuit 25, FM diversity circuit 26, diversity power supply circuit 27, LNA power supply circuit 28, or the like on the substrate.

Each of antenna elements TV1 to TV4 of the TV wave reception antenna 21 is connected with TV diversity circuit 25 respectively through above-mentioned low noise amplifier (LNA) 24.

Each of antenna elements FM1 to FM4 of the FM wave reception antenna 21 is connected with FM diversity circuit 26 respectively through above-mentioned low noise amplifier (LNA) 24.

The power supply is supplied to TV diversity circuit 25 and FM diversity circuit 26 from diversity power supply circuit 27. The power supply is supplied to low noise amplifier (LNA) 24 from LNA power supply circuit 28 through power supply control connector 6. Diversity power supply circuit 27 and LNA power supply circuit 28 is constructed to perform the predetermined voltage adjustment etc. for the power supply supplied from on-board battery 29 and output the adjusted result.

Connector group 5 (connector 5a for the AM/FM antenna signal, connector 5b for the FM-IF signal, connector 5c for the TV antenna signal and connector 5d for the video signal) and power supply control connector 6 are shown in the lower right part of FIG. 2. These connector groups 5 and power supply control connector 6 have structures, in which the female side member and the male material side are removably combined, respectively. In this embodiment, each of female side members is fixed to an end portion of the substrate of attached device section 2B (lower end portion in the figure), and each of the other male side members is attached to an end portion of the connection cable of the test device main body. FIG. 2 shows a state that the female side member and the male side member are coupled as one body, that is, shows a test state.

Connector 5a for the AM/FM antenna signal is connected with FM diversity circuit 26 and low noise amplifier (LNA) 24 provided to element AM of antenna 22 for AM wave. Connector 5b for FM-IF signal is connected with FM diversity circuit 26. Connector 5c for the TV antenna signal and connector 5d for the video signal are connected with TV diversity circuit 25.

At non-test state (at normal usage), the jumper connector (not shown) as the male side member is inserted in the female side member of power supply control connector 6, and each pair of terminals is short-circuited. Therefore, at non-test state (at normal usage), the power supply to which is supplied from on-vehicle battery 29 and in which the voltage etc. are adjusted by LNA power supply circuit 28, is simultaneously supplied to each power supply terminal of low noise amplifier (LNA) 24 through power supply control connector 6. Moreover, the wire harness (not shown) as the male side member on the test device main body side is coupled to instead of the jumper connector at test state. As a result, as described later, according to the control of the test device main body, it becomes possible to selectively supply the power supply to each power supply terminal of the low noise amplifier (LNA).

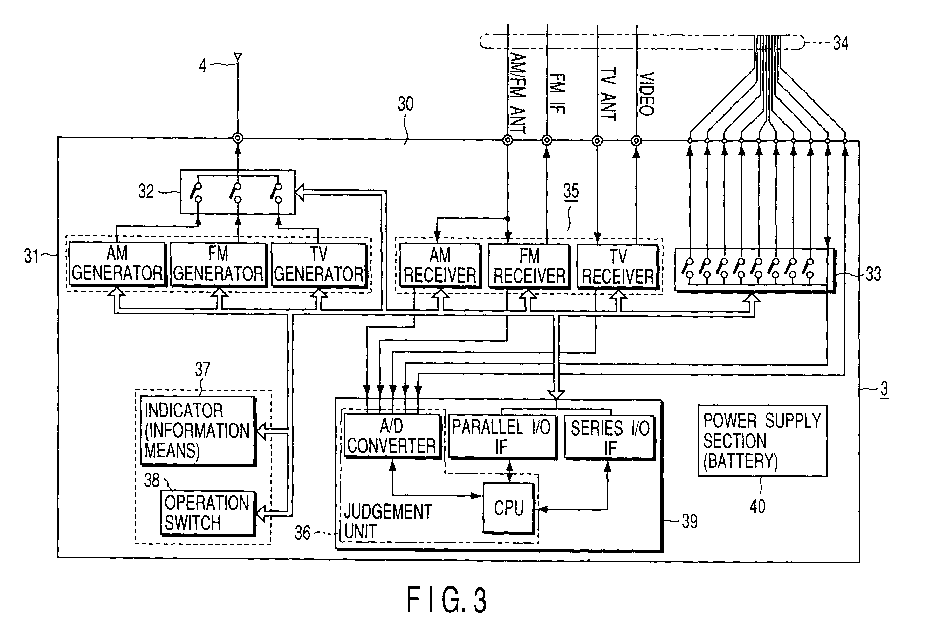

FIG. 3 is a figure which shows an internal configuration of test device main body 30 in mastless antenna test device 3. Test device main body 30 comprises transmission means including transmission antenna 4 which can selectively transmit various radio waves such as the TV wave, AM wave, and FM wave to the antenna section 2A of the pane antenna device 2. This transmission means mainly comprises generator 31 which includes the AM transmission section, the FM transmission section, and the TV transmission section, and select switch circuit 32 which selects the output from this generator 31 and sends it to transmission antenna 4.

Test device main body 30 comprises individual reception means which takes out and receives a specific antenna output among the plurality of antenna outputs obtained from the plurality of antenna elements in the antenna section 2A in response to one kind of radio waves transmitted by the transmission means.

This individual reception means mainly comprises specifying switch circuit 33 which specifies low noise amplifier 24 to be in the operation state, connection cable 34 which connects between test device main body 30 with the connector group 5 and power supply control connector 6, and receiver 35 which includes the AM receiver, the FM receiver, and the TV receiver to receive the antenna output etc. obtained through the connector group 5 so as to individually take out a specific antenna output (case of only of one channel and case of 1 to 4 channels, etc. are included).

Test device main body 30 comprises judgment means 36, which judges the quality of the antenna output received by the above-mentioned individual reception means. This judgment means 36 is specifically achieved with CPU which is the component of control means 39 to automatically control the transmission means and the individual reception means, and the A/D converter.

The judgment result by the judgment means 36, that is, the test result is displayed with above-mentioned indicator 37. For example, the buzzer etc. for abnormal information may be provided besides this indicator 37. Operation switch 38 includes various switches such as the power supply turning on switch, the initialization switch, the test starting switch, and automatic/manual operations switching switch. Power supply section 40 is a part to which the power supply to operate each section of test device main body 30 is supplied, and, for example, the battery is used as a power supply.

The AM/FM·ANT terminal provided to receiver 35 is a terminal to take the AM/FM antenna output sent from the pane antenna device 2 through the connector 5a, and FM-IF terminal is a terminal to send back the IF signal based on the sent FM antenna output to pane antenna device 2 (FM diversity circuit 26) as a reference signal which shows the reception state of FM wave through the connector 5b. The TV·ANT terminal is a terminal to take the TV antenna output sent from the pane antenna device 2 through the connector 5c, and the VIDEO terminal is a terminal to send back a video signal based on the sent TV antenna output to pane antenna device 2 (TV diversity circuit 25) as a reference signal which shows the reception state of the TV wave through the connector 5d.

### (Operation)

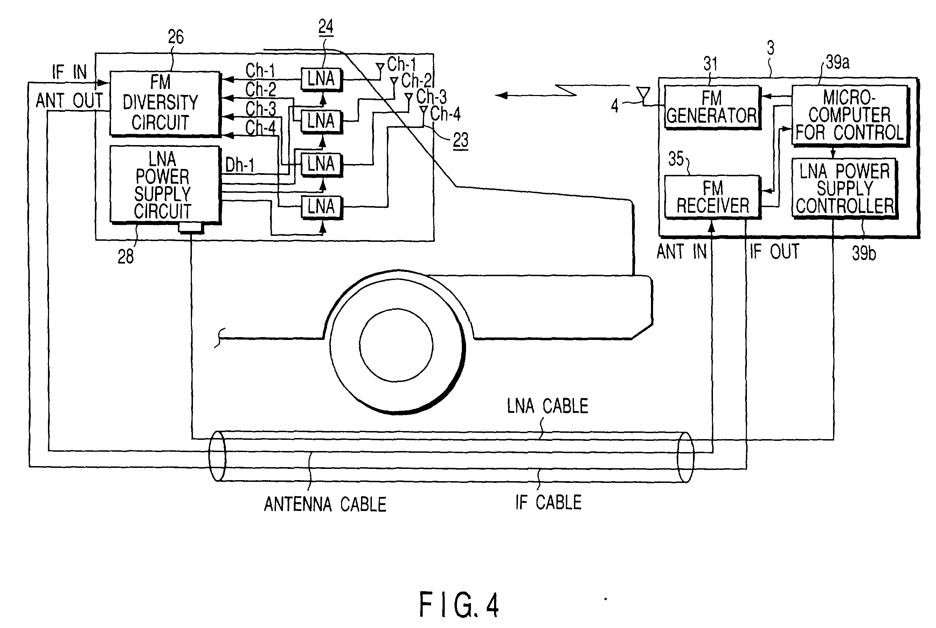

Next, an outline of the operation of the test device of this embodiment will be explained according to an example of the test of FM diversity function shown in FIG. 4.

An operation of test device main body 30 is started, and the output of FM transmission section in generator 31 is irradiated through transmission antenna 4 as a radio wave of the frequency which corresponds to the frequency modulation broadcasting frequency. When the channel specification operation is performed by using operation switch 38 of test device main body 30, to operate specifying switch circuit 33 by operating LNA power supply controller 39b in control means 39, the power supply output from LNA power supply circuit 28 in pane antenna device 2 is supplied to low noise amplifier (LNA) 24 of ch-1 in pane antenna device 2 after passing above-mentioned specifying switch circuit 33. At this time, FM diversity circuit 26 scans ch-1 to ch-4 cyclically. Though FM wave reception antenna 23 having the antenna elements of ch-1 to ch-4 receives the radio wave from the transmission antenna 4 of test device main body 30, since the power supply is supplied only to the low noise amplifier (LNA) 24 of ch-1, the ch-1 of an input of FM diversity circuit 26 becomes a best condition. That is, it becomes an excellent reception state since the antenna output signal of FM diversity circuit 26 becomes large when FM diversity circuit 26 scans ch-1.

On the other hand, FM diversity circuit 26 on pane antenna device 2 receives the IF signal which indicates the reception state from FM receiver in receiver 35. of test device main body 30 as a reference signal. And, above-mentioned FM diversity circuit 26 stops scanning of the antenna when judging that the reception is excellent by analyzing above-mentioned IF signal. As a result, the antenna element of excellent reception state is selected. And, ch-1 is judged the test passing if the reception signal level of FM receiver in receiver 35 of test device main body 30 is a range of regulations. This judgment result is displayed on indicator 37 which is the information means. When the test is failed, this result is displayed on indicator 37, the warning with, for example, the buzzer etc. is generated and the test failure is informed. Each test procedure and the judgment, etc. of test device main body 30 are performed by control microcomputer 39a etc. in the test device main body.

The test of ch-2 to ch-4 is performed in the same way. Since a basic principle of the test of the TV diversity function is similar to that of ch-1, the explanation will be omitted. Moreover, the explanation of the test of the reception function of the AM wave will be omitted since it is similar to the test of the reception function concerning one antenna element of FM wave.

### (Characteristic of Embodiment)

[1] The mastless antenna test device shown in the embodiment is characterized by comprising:
   a test device main body (30) which is removably connectably provided to a mastless antenna (2, 21, 22, 23) for a vehicle which is placed on vehicle pane etc. and is a object to be tested constructed by a plurality of antenna elements (TV1 to TV4, AM, FM1 to FM4) for receiving various electric waves such as TV wave, AM wave, and FM wave through connectors (5, 6),
   transmission means (31, 32, 4) to be placed in the test device main body (30) and to include transmission antenna (4) which can selectively transmit the various radio waves such as TV wave, AM wave and FM wave to the mastless antenna (2, 21, 22, 23),
   individual reception means (33, 34, 35, 39b) which individually takes out and receives a specific antenna output among a plurality of antenna outputs obtained from the plurality of antenna elements (TV1 to TV4, AM, FM1 to FM4) in response to one kind of radio waves transmitted from the transmission means (31, 32, 4),
   judgment means (36) which judges a quality of an antenna output received by the individual reception means (33, 34, 35, 39b), and
   information means (37) which informs a judgment result by the judgment means (36).
[2] The mastless antenna test device shown in the embodiment is a test device described in above-mentioned [1], and is characterized in that
   the judgment means (36) judges a quality of each antenna output corresponding to each channel (ch-1 to ch-4) and a quality of a diversity reception function according to a combination of each of these antenna outputs.
[3] The mastless antenna test device shown in the embodiment is a test device described in above-mentioned [1], and is characterized in that
   the test device main body (30) further comprises control means (39) for automatically controlling the transmission means (31, 32, 4) and the individual reception means (33, 34, 35, 39b).
[4] The mastless antenna test device shown in the embodiment is a test device described in above-mentioned [1], and is characterized in that
   the individual reception means (33, 34, 35, 39b) comprises power supply means (29, 28, 6, 33, 39b) to enable an individual reception by selectively supplying the power supply to a plurality of amplifiers (LNA 24) which amplifies the antenna output from each antenna element (TV1 to TV4, AM, FM1 to FM4), respectively.
[5] The mastless antenna test device shown in the embodiment is a test device described in above-mentioned [4], and is characterized in that
   the power supply means (29, 28, 6, 33, 39b) comprises a connector (6) for the power supply control which is capable of simultaneously supplying a power supply to a power supply terminal of each amplifier (LNA 24) by inserting a jumper connector at non-test state, and is capable of selectively supplying a power supply to the power supply terminal of the each amplifier (LNA 24) corresponding to the test device main body (30) by coupling a connector on a test device main body (30) side instead of the jumper connector at test state.

## Claims

1. A mastless antenna test device which is placed at least in part of a vehicle to test a mastless antenna (2, 21, 22, 23) for a vehicle having a plurality of antenna elements (TV1 to TV4, AM, FM1 to FM4) for receiving various electric waves including TV wave, AM wave, and FM wave, characterized by comprising:
a test device main body (30) which is removably connectable to said mastless antenna through connectors (5, 6);
transmission means (31, 32, 4) to be placed in said test device main body and to include transmission antenna (4) which can selectively transmit said various radio waves to said mastless antenna;
individual reception means (33, 34, 35, 39b) which individually takes out and receives a specific antenna output among a plurality of antenna outputs obtained from said plurality of antenna elements in response to one kind of radio waves transmitted from said transmission means;
judgment means (36) which judges a quality of an antenna output received by said individual reception means; and
information means (37) which informs a judgment result by said judgment means.

2. The mastless antenna test device according to claim 1, characterized in that said judgment means judges a quality of each antenna output corresponding to each channel and a quality of a diversity reception function according to a combination of each of these antenna outputs.

3. The mastless antenna test device according to claim 1, characterized by further comprising control means (39) for automatically controlling said transmission means and said individual reception means.

4. The mastless antenna test device according to claim 1, characterized in that said individual reception means comprises power supply means (29, 28, 6, 33, 39b) to enable an individual reception by selectively supplying the power supply to a plurality of amplifiers which amplifies the antenna output from each antenna element, respectively.

5. The mastless antenna test device according to claim 4, characterized in that said power supply means comprises a connector (6) for the power supply control which is capable of simultaneously supplying a power supply to a power supply terminal of each amplifier by inserting a jumper connector at non-test state, and is capable of selectively supplying a power supply to the power supply terminal of said each amplifier corresponding to said test device main body by coupling a connector on a test device main body side instead of said jumper connector at test state.
